# FASCICULE DE BREVET EUROPEEN

(11) **EP 4 213 181 B1**
(45) Date de publication et mention de la délivrance du brevet: **11.09.2024**
(21) Numéro de dépôt: 22213952.9
(22) Date de dépôt: 15.12.2022
(51) Int. Cl.: H01L 21/18, H01L 21/20, H01L 21/306

(54) **PROCÉDÉ D'ACTIVATION D'UNE COUCHE EXPOSÉE**
VERFAHREN ZUR AKTIVIERUNG EINER BELICHTETEN SCHICHT
METHOD OF ACTIVATING AN EXPOSED LAYER

(30) Priorité: 29.12.2021 FR 2114613
(43) Date de publication de la demande: 19.07.2023
(73) Titulaire: Commissariat à l'Energie Atomique et aux Energies Alternatives, 75015 Paris (FR)
(72) Inventeur: BRIANCEAU, Pierre, 38054 Grenoble Cedex 09 (FR); POSSEME, Nicolas, 38054 Grenoble Cedex 09 (FR); VERMANDE, Elisa, 38054 Grenoble Cedex 09 (FR)
(74) Mandataire: Hautier IP

(56) Documents cités:
- US-A- 5 603 779
- US-A1- 2011 129 986

## Description

### DOMAINE TECHNIQUE

La présente invention concerne le domaine des procédés d'activation d'une surface d'une structure telle qu'un substrat. D'une manière générale, le domaine des dispositifs microélectroniques est visé. Elle trouve pour application particulièrement avantageuse le domaine du collage direct de substrats.

### ETAT DE LA TECHNIQUE

Il est connu de façon générale d'assembler plusieurs substrats par collage direct pour la fabrication de dispositif microélectronique. Pour cela, il existe des solutions mettant en oeuvre un plasma d'activation permettant d'améliorer l'énergie de collage entre les substrats assemblés. Dans ces solutions, la couche exposée d'un substrat est typiquement traitée par un plasma d'activation à base d'oxygène ou d'azote, préalablement à l'assemblage. En pratique, l'énergie de collage obtenue reste trop limitée.

L'injection d'un gaz fluoré, tel que le tétrafluorure de carbone de formule chimique CF₄ ou l'hexafluorure de soufre de formule chimique SF₆ dans un plasma d'activation à base d'oxygène permet d'augmenter l'énergie de collage entre deux substrats assemblés suite à ce traitement. Cette solution s'avère limitée en pratique, notamment en raison d'une gravure de la couche exposée lors du traitement par le plasma d'activation.

Il est notamment connu du document US10434749 B2 un procédé comprenant la formation d'une couche de collage comprenant du fluor sur la couche exposée d'un substrat, préalablement à l'assemblage par collage direct du substrat avec un autre substrat. La couche de collage peut notamment être formée par le traitement d'une couche exposée par un plasma gravant comprenant du CF₄ ou SF₆. La couche de collage est activée et finalisée pour modifier sa chimie de surface préalablement au collage. Cette solution reste toutefois améliorable.

Des procédés d'activation de surface sont également connus des documents US 5 603 779 A et US 2011/129986 A1.

Un objet de la présente invention est donc de proposer une solution visant à améliorer le collage direct sur un substrat, et notamment visant à limiter la gravure de la couche exposée.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, selon un premier aspect on prévoit un procédé d'activation d'une couche exposée d'une structure comprenant :
- une fourniture d'une structure comprenant une couche exposée dans un réacteur, de préférence un réacteur plasma, le réacteur comprenant une chambre de réaction à l'intérieur de laquelle la structure est disposée,
- avant ou après la fourniture de la structure, un dépôt dans la chambre de réaction d'une couche à base d'un matériau de formule chimique CₓH_{y}F_{z}, x, y et z étant des entiers positifs, au moins x et z étant non-nuls,
- un traitement, en présence de la structure, de la couche à base d'un matériau de formule chimique CₓH_{y}F_{z} par un plasma d'activation à base de l'un au moins parmi de l'oxygène et de l'azote, le traitement par le plasma d'activation étant configuré pour consommer au moins en partie, de préférence totalement, la couche à base du matériau de formule chimique CₓH_{y}F_{z} de façon à activer la couche exposée de la structure.

Ce procédé permet ainsi de dissocier temporellement la formation d'une couche fluorée et l'activation par le plasma d'activation. Le collage subséquent est amélioré par une augmentation de l'énergie de collage. D'autre part, la consommation de la couche exposée est limitée par rapport aux solutions mettant en oeuvre un apport de gaz fluoré dans le plasma d'activation.

Lors du développement de l'invention, il a en outre été mis en évidence que le dépôt d'une couche de formule chimique CₓH_{y}F_{z} limite, et de préférence évite, la gravure de la couche exposée par rapport aux solutions existantes mettant en oeuvre un dépôt assisté par plasma à base de SF₆ ou CF₄, préalablement au plasma d'activation.

Le dépôt d'une couche de formule chimique CₓH_{y}F_{z}, aussi désignée couche CₓH_{y}F_{z}, préalablement à un plasma d'activation se démarque clairement des solutions existantes pour l'activation d'une couche exposée. Au contraire, la personne du métier serait dissuadée de déposer des espèces comprenant du carbone car le carbone est généralement considéré comme à proscrire pour obtenir de fortes énergies de collage. Dans le procédé, lors du plasma d'activation, le carbone de la couche CₓH_{y}F_{z} est retiré sous forme de rejet gazeux, par exemple sous forme de gaz de formule CO, CO₂, ou CN. Une augmentation de l'énergie de collage peut être obtenue tout en limitant la gravure de la couche.

En outre, cette solution diffère des solutions existantes mettant en oeuvre un plasma de CF₄, qui induisent une gravure de la couche exposée, et ne permettent pas de déposer une couche fluorée en surface de la couche exposée.

Afin de limiter la gravure de la couche exposée, la personne du métier aurait plutôt envisagé de diminuer la concentration de CF₄ ou SF₆ ajoutés à un plasma O₂ de gravure, ce qui réduirait les énergies de collage résultantes. Le dépôt d'une couche de formule chimique CₓH_{y}F_{z} préalablement à un plasma d'activation permet une meilleure reproductibilité et un gain de temps.

Un deuxième aspect de l'invention concerne un procédé de collage d'une couche exposée d'une structure avec une couche exposée d'un substrat distinct, le procédé comprenant :
- l'activation de la couche exposée de la structure en mettant en oeuvre le procédé selon le premier aspect,
- la mise en contact de la couche exposée de la structure avec la couche exposée du substrat distinct.

De préférence, la couche exposée de la structure avec la couche exposée du substrat distinct sont assemblées par collage direct. Ce procédé présente les effets et avantages du procédé selon le premier aspect. Le procédé de collage permet d'obtenir un assemblage présentant une interface de collage, entre la couche exposée de la structure et la couche exposée du substrat distinct, améliorée par rapport aux solutions existantes. Le procédé de collage permet d'obtenir un assemblage présentant une énergie de collage améliorée par rapport aux solutions existantes.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La figure 1 représente une vue en coupe transversale d'une structure présentant une couche exposée, selon un exemple de réalisation.
La figure 2A représente une vue en coupe transversale de la chambre de réaction d'un réacteur, durant un exemple de dépôt d'une couche à base du matériau de formule CₓH_{y}F_{z} sur la couche exposée de la structure selon l'exemple de réalisation illustré en figure 1.
La figure 2B représente une vue en coupe transversale de la chambre de réaction d'un réacteur, après le dépôt d'une couche à base du matériau de formule chimique CₓH_{y}F_{z} sur la couche exposée de la structure, selon l'exemple de réalisation illustré en figure 2A.
La figure 2C représente une vue en coupe transversale de la structure présentant la couche exposée et la couche à base du matériau de formule chimique CₓH_{y}F_{z}, selon l'exemple de réalisation illustré en figure 2B.
La figure 2D représente, une vue en coupe transversale d'un exemple de traitement par le plasma d'activation de la structure selon l'exemple de réalisation illustré en figure 2C.
La figure 3A représente une vue en coupe transversale de la chambre de réaction d'un réacteur, durant le dépôt d'une couche à base du matériau de formule CₓH_{y}F_{z}, selon un exemple de réalisation.
La figure 3B représente une vue en coupe transversale de la chambre de réaction d'un réacteur, après le dépôt d'une couche à base du matériau de formule chimique CₓH_{y}F_{z} sur les parois de la chambre de réaction, selon l'exemple de réalisation illustré en figure 3A.
La figure 3C représente une vue en coupe transversale de la chambre de réaction d'un réacteur comprenant la structure selon l'exemple de réalisation illustré en figure 1, lors du traitement par le plasma d'activation, selon l'exemple de réalisation illustré en figure 3B.
La figure 4 représente, une vue en coupe de la structure présentant une couche exposée activée, par exemple suite aux exemples illustrés par les figures 2D ou 3C.
La figure 5 représente, une vue en coupe d'un assemblage de la structure présentant une couche exposée activée selon l'exemple illustré en figure 4, avec la couche exposée d'un substrat distinct.
La figure 6 représente de manière schématique un exemple de réacteur pouvant être utilisé pour mettre en oeuvre le procédé selon l'invention.
La figure 7 représente un graphique de l'énergie de collage d'un assemblage d'une structure présentant une couche exposée activée, avec la couche exposée d'un substrat distinct, selon plusieurs exemples de réalisation du procédé et des exemples comparatifs.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs des différentes couches ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement.

Selon un exemple, la fourniture de la structure est effectuée avant le dépôt de la couche à base d'un matériau de formule chimique CₓH_{y}F_{z} dans la chambre de réaction, la couche à base d'un matériau de formule chimique CₓH_{y}F_{z} étant alors déposée sur la couche exposée de la structure. La source de fluor est alors apportée au plus près de la couche exposée, en déposant la couche CₓH_{y}F_{z} sur la couche exposée, tout en limitant la gravure de la couche exposée. Une bonne répétabilité de l'énergie de collage résultante est obtenue entre différentes structures traitées par le procédé.

Selon un exemple, le dépôt de la couche à base d'un matériau de formule chimique CₓH_{y}F_{z} et le traitement par le plasma d'activation sont réalisés dans la même chambre de réaction. Cela permet de simplifier le procédé, de le rendre moins coûteux et plus aisément reproductible.

Selon un exemple, le substrat est laissé dans la chambre de réaction entre le dépôt de la couche à base d'un matériau de formule chimique CₓH_{y}F_{z} et le traitement par le plasma d'activation.

Selon un exemple, la fourniture de la structure est effectuée après le dépôt de la couche à base d'un matériau de formule chimique CₓH_{y}F_{z} dans la chambre de réaction et avant le traitement par le plasma d'activation, la couche à base d'un matériau de formule chimique CₓH_{y}F_{z} étant alors déposée sur des parois de la chambre de réaction. Le dépôt de la couche à base d'un matériau de formule chimique CₓH_{y}F_{z} et le traitement par le plasma d'activation sont de préférence réalisés dans la même chambre de réaction. La source de fluor est ainsi apportée à proximité de la couche exposée, tout en limitant la gravure de la couche exposée. Une bonne reproductibilité de l'énergie de collage résultante est obtenue.

Selon un exemple le traitement par le plasma d'activation est effectué de façon à consommer au moins 90% et de préférence tous les atomes de carbone de la couche déposée à base d'un matériau de formule chimique CₓH_{y}F_{z}. Selon un exemple, à l'issue du traitement par le plasma d'activation, il ne reste plus ou tout au moins il reste moins de 10 % des atomes de carbone qui étaient présents dans la couche à base d'un matériau de formule chimique CₓH_{y}F_{z} après le dépôt et avant le traitement par le plasma d'activation. Ainsi, le traitement par le plasma d'activation permet de retirer l'élément carbone pouvant impacter l'énergie de collage et/ou les propriétés du dispositif microélectronique résultant.

Selon un exemple, le traitement par le plasma d'activation comprend l'application d'une tension dans la chambre de réaction, dite tension d'auto-polarisation, de préférence la tension d'auto-polarisation est non nulle. Ainsi, l'énergie des ions du plasma d'activation peut être modulée pour améliorer l'efficacité du bombardement ionique sur la couche CₓH_{y}F_{z} et donc l'activation de la couche exposée, tout en limitant la gravure de la couche exposée.

Selon un exemple, la valeur absolue de la tension d'auto-polarisation est sensiblement supérieure ou égale à 100 V, de préférence sensiblement supérieure ou égale à 200 V. Selon un exemple, la valeur absolue de la tension d'auto-polarisation est sensiblement inférieure ou égale à 500 V. Selon un exemple, la valeur absolue de la tension d'auto-polarisation est sensiblement comprise entre 100 V et 500 V.

Selon un exemple, le traitement par le plasma d'activation est réalisé dans une chambre de réaction d'un réacteur plasma à couplage capacitif.

Selon un exemple, le traitement par le plasma d'activation est réalisé dans une chambre de réaction d'un réacteur plasma à couplage inductif.

Selon un exemple, lors du traitement par le plasma d'activation, une tension de polarisation V_{bias-substrat} est appliquée à la structure. Ainsi, le bombardement ionique sur la couche CₓH_{y}F_{z} et la gravure de la couche exposée peuvent être encore mieux contrôlés et de préférence minimisés Selon un exemple, la tension de polarisation V_{bias-substrat} est non nulle. Selon un exemple, la tension appliquée à la structure V_{bias-substrat} est choisie de sorte que la valeur absolue de la tension d'auto-polarisation est comprise entre 100 V et 500 V.

Selon un exemple, la tension de polarisation V_{bias-substrat} appliquée à la structure est pulsée. Cela permet une plus grande fenêtre de paramètres pour minimiser la gravure de la couche exposée tout en permettant son activation.

Selon un exemple, une tension de polarisation V_{bias-substrat} est appliquée à la structure de façon indépendante à la puissance radiofréquence (RF) de la source du plasma Pₛ₋ₚₗₐₛₘₐ.

Selon un exemple, le dépôt de la couche à base d'un matériau de formule chimique CₓH_{y}F_{z} est un dépôt chimique à partir d'au moins un précurseur gazeux. De préférence, le dépôt est assisté par plasma.

Selon un exemple, l'au moins un précurseur gazeux comprend au moins les éléments carbone, et fluor, l'au moins un précurseur gazeux étant différent de CF₄.

Selon un exemple, l'au moins un précurseur gazeux est de formule chimique CᵤHᵥF_{w}, u, v et w étant des entiers positifs, au moins u et w étant non nuls, hors CF₄. Selon un exemple u, v et w sont des entiers positifs non-nuls. Par exemple l'au moins un précurseur gazeux est choisi parmi les composés de formule CH₂F₂ et CHF₃ et CH₃F et CᵤF_{w} hors CF₄, par exemple C₄F₈, C₄F₆. En effet, un plasma de CF₄ ne permet pas de déposer une couche fluorée, contrairement à un plasma comprenant d'autres précurseurs CᵤF_{w} tels que le C₄F₈, C₄F₆. Un plasma de CF₄ seul induit la gravure de la couche exposée.

Selon un exemple, lors du dépôt de la couche à base d'un matériau de formule chimique CₓH_{y}F_{z}, la couche exposée n'est pas gravée.

Selon un exemple le plasma d'activation est à base d'azote et/ou d'oxygène.

Selon un exemple, le traitement par le plasma d'activation comprend une injection d'au moins un gaz dans une chambre de réaction d'un réacteur plasma et une formation du plasma d'activation à partir dudit gaz dans la chambre de réaction Selon un exemple, l'au moins un gaz comprend du dioxygène, du diazote, de l'hélium, de l'argon ou leur mélange.

Selon un exemple, le plasma d'activation est exempt d'espèce halogénée et en particulier de fluor. Le plasma d'activation peut ne pas comprendre d'injection d'un gaz comprenant d'élément halogène et en particulier l'élément fluor dans la chambre de réaction. La gravure de la couche exposée est donc minimisée, voire évitée. Ainsi, ce procédé se différencie clairement des solutions connues consistant à effectuer un traitement par un plasma d'activation avec l'injection d'un gaz comprenant l'élément fluor.

Selon un exemple, le plasma d'activation est configuré pour ne pas déposer de couche sur la couche exposée et/ou les parois de la chambre de réaction.

Selon un exemple, la couche exposée est à base d'un semi-conducteur ou d'un métal ou d'un métalloïde. Par exemple la couche exposée est à base ou faite d'un oxyde métallique, par exemple d'un oxyde de semi-conducteur, d'un nitrure métallique, par exemple d'un nitrure de semi-conducteur.

Selon un exemple, la couche exposée est à base de silicium. Par exemple la couche exposée est à base ou faite d'un oxyde de silicium, d'un nitrure de silicium ou de silicium.

Selon un exemple, après le traitement par le plasma d'activation, le procédé peut comprendre l'assemblage de la couche exposée de la structure avec une couche exposée d'un substrat distinct.

Selon un exemple, au moins l'un parmi le dépôt de la couche à base d'un matériau de formule chimique CₓH_{y}F_{z} et le traitement par le plasma d'activation peuvent être répétés plusieurs fois. Selon un exemple, au moins l'un parmi le dépôt et le traitement par le plasma d'activation peuvent être répétés plusieurs fois avant l'assemblage de la couche exposée de la structure avec une couche exposée d'un substrat distinct. De préférence, le dépôt de la couche à base d'un matériau de formule chimique CₓH_{y}F_{z} et le traitement par le plasma d'activation forment un cycle pouvant être répété plusieurs fois.

Par dispositif microélectronique, on entend tout type de dispositif réalisé avec les moyens de la microélectronique. Ces dispositifs englobent notamment, en plus des dispositifs à finalité purement électronique, des dispositifs micromécaniques ou électromécaniques (MEMS, de l'anglais *microelectromechanical systems* que l'on peut traduire par systèmes microélectromécaniques, NEMS, de l'anglais *nanoelectromechanical systems* que l'on peut traduire par systèmes nanoélectromécaniques,...) ainsi que des dispositifs optiques ou optoélectroniques (MOEMS, de l'anglais *Micro-Opto-Electro-Mechanical System* que l'on peut traduire par microsystèmes opto-électro-mécaniques,...).

Il peut s'agir d'un dispositif destiné à assurer une fonction électronique, optique, mécanique etc. Il peut aussi s'agir d'un produit intermédiaire uniquement destiné à la réalisation d'un autre dispositif microélectronique.

On entend par « collage direct » un collage sans apport de matière adhésive (de type colle ou polymère notamment) qui consiste en la mise en contact de surfaces relativement lisses (d'une rugosité typiquement inférieure à 5 Å, 10⁻⁹ m), par exemple réalisé à température ambiante et sous atmosphère ambiante, afin de créer une adhérence entre elles.

Selon un exemple, le collage direct de deux substrats signifie que le collage est obtenu par les liens chimiques qui s'établissent entre les deux surfaces mises en contact.

Le collage direct peut être obtenu sans nécessiter l'application d'une pression importante sur la structure à assembler. Une légère pression pourra simplement être appliquée pour initier le collage. Un recuit thermique peut en outre être effectué pour consolider le collage.

On entend par un substrat, une couche, une zone ou une portion « à base » d'un matériau A, un substrat, une couche, une zone ou une portion comprenant ce matériau A, par exemple à hauteur d'au moins 50%, et éventuellement d'autres matériaux, par exemple des éléments dopants.

De manière parfaitement classique, une structure à base d'un oxyde métallique est une structure faite, ou comprenant un matériau comprenant au moins un métal ou un métalloïde et de l'oxygène. Une structure à base d'un nitrure métallique est une structure faite, ou comprenant un matériau comprenant au moins un métal ou un metalloïde et de l'azote.

Le mot « diélectrique » qualifie un matériau dont la conductivité électrique est suffisamment faible dans l'application donnée pour servir d'isolant. Dans la présente invention, un matériau diélectrique présente de préférence une constante diélectrique supérieure à 4.

Il est précisé que dans le cadre de la présente invention, le terme « sur », « surmonte », ou leurs équivalents ne signifient pas forcément « au contact de », sauf mention contraire de « juxtaposé ». Par des couches, ou portions, ou zones « juxtaposés » on entend ici que les couches, ou portions, ou zones sont en contact selon leur plan d'extension principale et disposées les unes au-dessus des autres selon la direction de l'empilement, cette direction étant perpendiculaire au plan d'extension principale. Par « en contact », on entend qu'une fine interface puisse exister, par exemple causée par la variabilité de fabrication.

Dans la description qui suit, les épaisseurs de couche, de zone ou de portion ainsi que les profondeurs sont généralement mesurées selon une direction verticale, parallèle à la direction d'empilement et perpendiculaire au plan principal d'extension du substrat, de la couche, de la sous-couche ou de la portion.

Par ailleurs, un plasma à base d'azote et/ou d'oxygène peut être basé sur une chimie comprenant uniquement de l'azote et/ou de l'oxygène ou comprenant de l'azote et/ou de l'oxygène et éventuellement une ou plusieurs autres espèces, par exemple des gaz neutres (tels que l'hélium ou l'argon par exemple).

Dans la présente demande de brevet lorsque l'on exprime un mélange gazeux avec des pourcentages, ces pourcentages correspondent à des fractions du débit total des gaz injectés dans le réacteur. Ainsi, si un mélange gazeux, par exemple destiné à former un plasma, comprend x % du gaz A, cela signifie que le débit d'injection du gaz A correspond à x % du débit total des gaz injectés dans le réacteur pour former le plasma.

Plusieurs modes de réalisation de l'invention mettant en oeuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

On entend par un paramètre « sensiblement égal/supérieur/inférieur à » une valeur donnée, que ce paramètre est égal/supérieur/inférieur à la valeur donnée, à plus ou moins 10 % près, voire à plus ou moins 5 % près, de cette valeur. On entend par un paramètre « sensiblement compris entre » deux valeurs données que ce paramètre est au minimum égal à la plus petite valeur donnée, à plus ou moins 10 %, près de cette valeur, et au maximum égal à la plus grande valeur donnée, à plus ou moins 10 %, près de cette valeur.

Le procédé d'activation est maintenant décrit à titre non limitatif selon plusieurs exemples de réalisation.

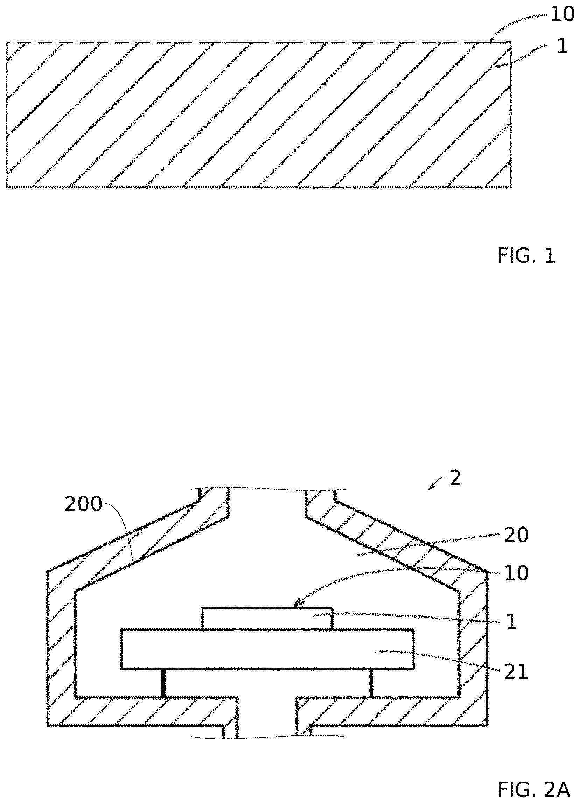

Le procédé est configuré pour activer la couche exposée 10 d'une structure 1, par exemple illustrée par la figure 1. Une telle structure est par exemple à base d'un matériau semi-conducteur. Dans l'exemple non limitatif qui va être décrit en détail, cette structure 1 est à base ou faite de silicium. Cette structure 1 peut être à base ou faite d'un oxyde de silicium, d'un nitrure de silicium ou de silicium. La structure 1 peut être du silicium massif dit « bulk ». Par ailleurs, toutes les caractéristiques, étapes et effets techniques qui seront décrits par la suite sont parfaitement applicables à une structure 1, possiblement autre qu'une couche, telle qu'une nanostructure, par exemple en trois dimensions, ou une pluralité de telles structures.

La structure 1 peut faire partie d'un substrat. Ce substrat peut être formé uniquement de cette structure 1. De manière alternative, ce substrat peut comprendre une couche de support surmontée au moins d'une telle structure 1. La structure présente une couche exposée 10, libre et exposée aux espèces environnantes, par exemple présentes dans la chambre de réaction 20 d'un réacteur 2.

Pour activer la couche exposée 10, le procédé comprend principalement trois étapes : une étape de fourniture de la structure, une étape de dépôt et une étape de traitement. Le procédé comprend le dépôt d'une couche fluorée 11 à base d'un matériau de formule chimique CₓH_{y}F_{z}, x, y et z étant des entiers positifs, au moins x et z étant non nuls, et un plasma d'activation 3 configuré pour consommer au moins en partie, de préférence totalement, cette couche 11 et ainsi activer la couche exposée 10. La couche fluorée 11 peut donc être à base d'un matériau de formule chimique CₓH_{y}F_{z} ou CₓF_{z} lorsque y = 0. Selon un exemple, x, y et z sont des entiers positifs non-nuls. Dans la suite, la couche 11 à base d'un matériau de formule chimique CₓH_{y}F_{z} est désignée couche CₓH_{y}F_{z} 11 ou encore couche 11. On comprend que le plasma d'activation est une étape temporellement distincte de l'étape de dépôt de la couche CₓH_{y}F_{z} 11, ces deux étapes ne sont pas simultanées.

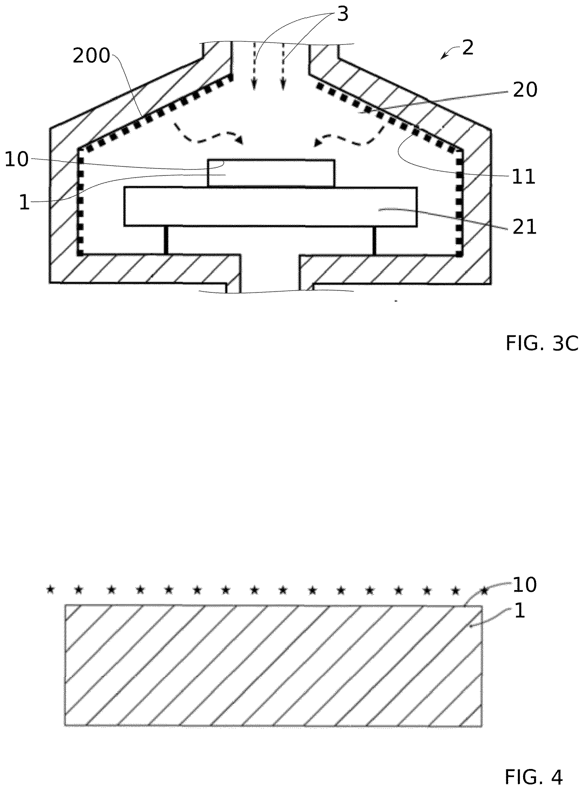

Le procédé est configuré pour déposer la couche CₓH_{y}F_{z} 11 de sorte que, lors du traitement successif par le plasma d'activation 3 à base d'oxygène et/ou d'azote, la couche CₓH_{y}F_{z} 11 est située à proximité de la couche exposée 10. Le plasma d'activation 3 consomme au moins en partie la couche CₓH_{y}F_{z} 11. Les réactions se déroulant lors de la consommation de la couche CₓH_{y}F_{z} 11 induisent une activation de la couche exposée 10, par exemple illustrée en figure 4 dans laquelle les étoiles symbolisent l'activation de la couche exposée 10. La couche exposée 10 une fois activée présente notamment en surface des liaisons avec des atomes de fluor. Ces liaisons de surface permettent d'augmenter l'énergie de collage lors d'un assemblage de la structure avec un autre substrat. Le carbone présent dans la couche CₓH_{y}F_{z} 11 sera retiré par le plasma d'activation 3 sous forme de produits volatils.

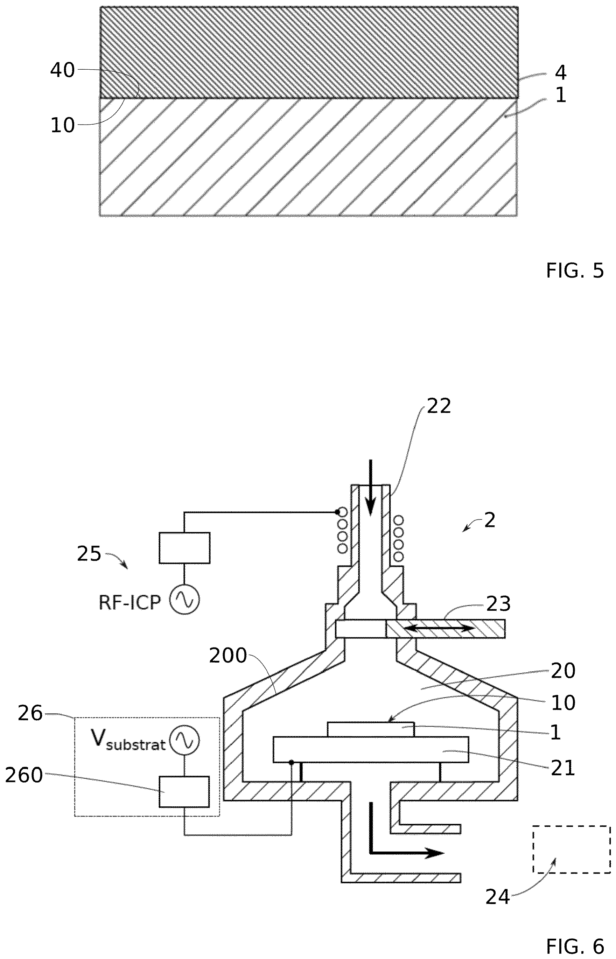

Suite à l'activation de la couche exposée 10, le procédé peut en outre comprendre une étape d'assemblage de la structure 1 avec un substrat ou une structure distinct(e). La couche exposée 10 peut être assemblée par collage direct à la couche exposée 40 du substrat 4 ou de la structure 4, comme par exemple illustré par la figure 5. La structure 4 peut faire partie d'un substrat. Ce substrat peut être formé uniquement de cette structure 4. De manière alternative, ce substrat peut comprendre une couche de support surmontée au moins d'une telle structure 4.

Pour l'activation de la couche exposée 10, deux exemples de réalisation du procédé sont décrits relativement aux figures 2A à 2D, puis 3A à 3C.

Selon le premier exemple illustré par les figures 2A à 2D, la structure 1 est fournie à l'intérieur de la chambre de réaction 20 d'un réacteur 2, par exemple un réacteur plasma. La structure 1 peut plus particulièrement être placée sur le plateau ou porte échantillon 21 dans la chambre de réaction 20, comme par exemple illustré par la figure 2A.

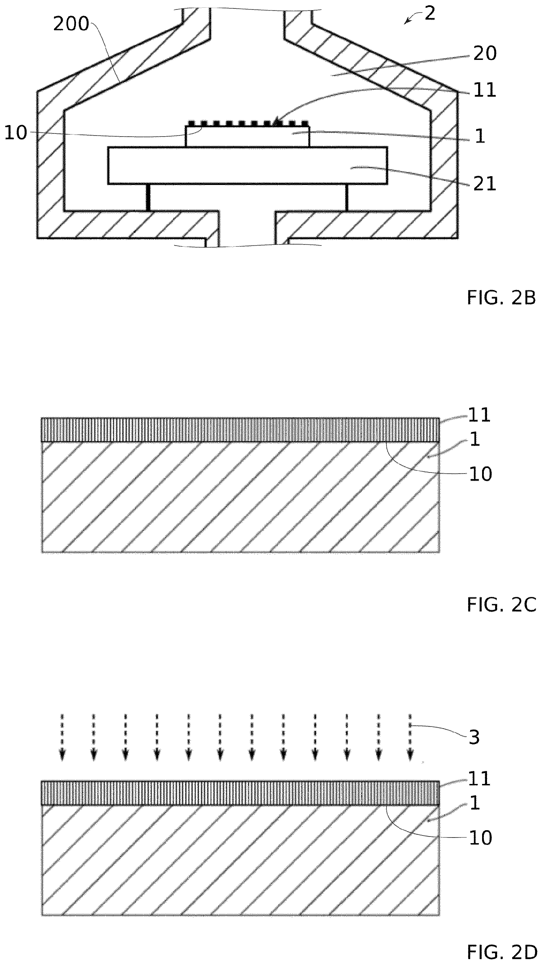

La structure 1 étant placée dans la chambre de réaction 20, le procédé peut comprendre le dépôt de la couche CₓH_{y}F_{z} 11, comme par exemple illustré par les figures 2A et 2B. La couche CₓH_{y}F_{z} 11 est alors déposée sur, et de préférence directement en contact avec, la couche exposée 10, comme l'illustre par exemple la figure 2C. Notons que durant ce dépôt de la couche CₓH_{y}F_{z} 11, le matériau CₓH_{y}F_{z} peut en outre être déposé sur les parois 200 de la chambre de réaction 20.

Le procédé comprend ensuite le traitement de la couche CₓH_{y}F_{z} 11 par le plasma d'activation 3 à base d'oxygène et/ou d'azote, comme par exemple illustré par la figure 2D. La couche CₓH_{y}F_{z} 11 sur la couche exposée 10 est alors au moins en partie consommée. Le plasma d'activation réagit avec le matériau CₓH_{y}F_{z}. Lors de cette réaction, le carbone est retiré sous forme de gaz, par exemple sous la forme de formule chimique CO, CO₂, CN selon la chimie du plasma. Le fluor contenu dans la couche CₓH_{y}F_{z} 11 réagit avec la couche exposée 10, ce qui induit son activation. Avantageusement, le traitement par le plasma d'activation 3 permet de retirer l'élément carbone pouvant impacter l'énergie de collage et/ou les propriétés du dispositif microélectronique résultant. Pour cela on peut par exemple régler les paramètres du plasma, tels que la puissance de la source, la pression dans la chambre de réaction 20, la durée du plasma et/ou la teneur dans le plasma des espèces qui réagissent avec le carbone pour former des produits volatils

De préférence, le traitement par le plasma d'activation 3 est effectué de façon à consommer au moins 90% et de préférence tous les atomes de carbone de la couche CₓH_{y}F_{z} 11. Selon un exemple, la couche CₓH_{y}F_{z} 11 est au moins à 90 % et de préférence totalement consommée. Ainsi, il ne reste plus de matériau CₓH_{y}F_{z} 11 lors d'un assemblage ultérieur avec la couche exposée 40 d'un autre substrat 4, par exemple illustré par la figure 5. Le collage et/ou les propriétés du dispositif microélectronique résultant sont ainsi encore améliorés. La qualité de l'interface entre la couche exposée 10 et la couche exposée 40 après assemblage est améliorée.

Les propriétés, par exemple la quantité d'atomes de carbone restant, de la couche exposée 10 après traitement par le plasma d'activation 3 peuvent être analysée par une caractérisation de la couche exposée 10, par exemple par analyse par spectrométrie photoélectronique X (communément abrégé XPS, de l'anglais *X-Ray photoelectron spectrometry*). La couche exposée 10 une fois activée présente notamment en surface des liaisons avec des atomes de fluor, et de préférence en outre des liaisons avec les atomes d'hydrogène. A titre d'exemple, après traitement par un plasma d'activation 3 à base d'O₂, la couche exposée 10 à base de silicium peut présenter une surface de type SiOₓF_{y}H_{z} dans le cas d'un substrat Silicium-sur-isolant (communément abrégé SOI, de l'anglais *Silicon-on-Isulator*). Selon un autre exemple, après traitement par un plasma d'activation 3 à base de N₂, la couche exposée 10 à base de silicium peut présenter une surface de type SiOₓF_{y}H_{z}N_{w} dans le cas d'un substrat Silicium-sur-isolant. A noter que l'hydrogène n'est pas détecté en XPS.

Selon cet exemple, le dépôt de la couche CₓH_{y}F_{z} 11 et le traitement par le plasma d'activation 3 peuvent être faits dans la même chambre de réaction 20. De préférence, le substrat est laissé dans la chambre de réaction 20 entre le dépôt de la couche CₓH_{y}F_{z} 11 et le traitement par le plasma d'activation 3. La présence d'impureté sur la couche CₓH_{y}F_{z} 11 et dans la couche exposée 10 est ainsi mieux contrôlée, et de préférence évitée. En alternative le dépôt de la couche CₓH_{y}F_{z} 11 et le traitement par le plasma d'activation 3 peuvent être fait dans des chambres de réaction 20 distinctes.

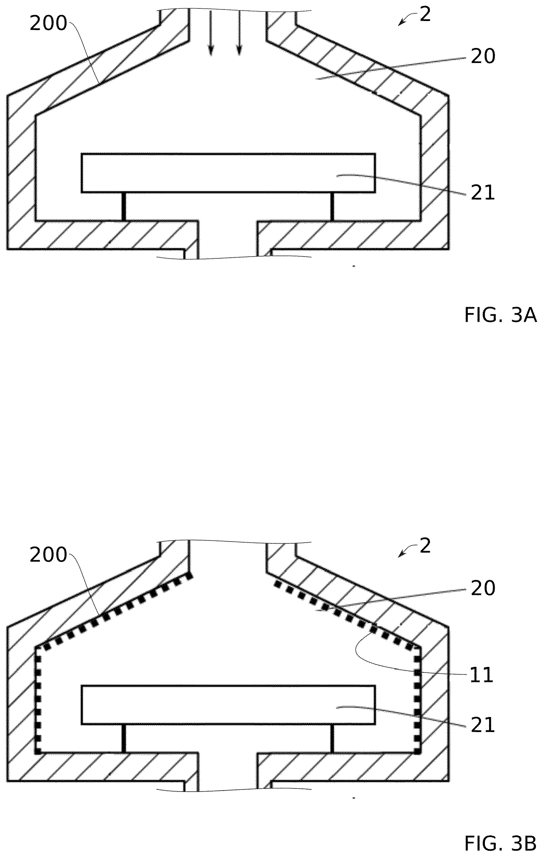

Selon le deuxième exemple illustré par les figures 3A à 3D, le procédé peut comprendre le dépôt de la couche CₓH_{y}F_{z} 11 alors que la structure n'est pas fournie à l'intérieur de la chambre de réaction 20 du réacteur 2, par exemple un réacteur plasma, comme par exemple illustré par les figures 3A et 3B. Le dépôt est alors configuré de sorte que la couche CₓH_{y}F_{z} 11 est déposée sur les parois 200 de la chambre de réaction 20, comme l'illustre par exemple la figure 3B.

Le procédé comprend ensuite la fourniture de la structure 1 à l'intérieur de la chambre de réaction 20, par exemple sur le porte échantillon 21. Le traitement par le plasma d'activation 3 à base d'oxygène et/ou d'azote est configuré pour consommer au moins en partie la couche CₓH_{y}F_{z} 11, comme par exemple illustré par la figure 3C. Le plasma d'activation réagit avec le matériau CₓH_{y}F_{z}. Lors de cette réaction, le carbone est retiré sous forme de gaz, par exemple sous la forme de CO, CO₂, CN, selon la chimie du plasma. Le fluor contenu dans la couche CₓH_{y}F_{z} 11 sur les parois 200, sous l'influence du plasma d'activation 3, réagit avec la couche exposée 10 disposée dans la chambre 200, ce qui induit l'activation de la couche exposée 10. Avantageusement, le traitement par le plasma d'activation 3 évite l'incorporation de carbone sur la couche exposée 10, pouvant impacter l'énergie de collage et/ou les propriétés du dispositif microélectronique résultant. On veillera notamment à ce que l'énergie du plasma d'activation ne permette pas aux espèces carbonées de s'introduire dans la couche exposée 10 que l'on souhaite activer.

De préférence, le traitement par le plasma d'activation 3 est effectué de façon à consommer au moins 90% et de préférence tous les atomes de carbone de la couche CₓH_{y}F_{z} 11. Selon un exemple, la couche CₓH_{y}F_{z} 11 est au moins à 90 % et de préférence totalement consommée. Selon un exemple, la couche CₓH_{y}F_{z} 11 est totalement consommée pour qu'il ne reste plus de matériau CₓH_{y}F_{z} sur les parois 200. Pour vérifier cela, il est par exemple possible de prélever un échantillon sur les parois 200 et d'effectuer une analyse XPS sur cet échantillon pour vérifier la présence ou non de matériau CₓH_{y}F_{z}. Il est en outre possible de faire un plasma d'activation sur un substrat sur lequel n'a pas été déposée une couche carbonée au préalable, et suivre une raie type du carbone, par exemple celle du monoxyde de carbone CO, lors du plasma et/ou faire analyse XPS sur le substrat.

Que la couche CₓH_{y}F_{z} soit déposée sur la couche exposée 10 et/ou sur les parois 200 de la chambre de réaction 20, la gravure de la couche exposée 10 est limitée, et de préférence évitée, tout en apportant une source de fluor à proximité de la couche exposée 10, pour l'activation de la couche exposée lors du traitement par le plasma d'activation 3.

Au moins l'un parmi le dépôt de la couche CₓH_{y}F_{z} 11 et le traitement par le plasma d'activation 3 peuvent être répétés plusieurs fois. Plusieurs agencements d'étapes peuvent par exemple être prévus. On peut prévoir que le dépôt de la couche CₓH_{y}F_{z} 11, puis la fourniture de la structure 1 dans la chambre de réaction 20, puis le traitement par le plasma d'activation soient répétés plusieurs fois. On peut prévoir que, suite à la fourniture de la structure dans la chambre de réaction 20, le dépôt de la couche CₓH_{y}F_{z} 11 puis le traitement par le plasma d'activation soient répétés plusieurs fois. On peut prévoir en outre des exemples dans lesquels les deux exemples de réalisations du procédé présentés ci-dessus sont combinés.

Le dépôt de la couche CₓH_{y}F_{z} 11 est maintenant décrit plus en détail. Le dépôt de la couche CₓH_{y}F_{z} 11 peut être un dépôt chimique en phase vapeur (communément abrégé CVD, de l'anglais *Chemical Vapor Deposition).* Le dépôt de la couche CₓH_{y}F_{z} 11 peut être un dépôt chimique en phase vapeur assisté par plasma (communément abrégé PE-CVD, de l'anglais *Plasma Enhanced Chemical Vapor Déposition*). Un dépôt assisté par plasma permet une meilleure conformité et/ou uniformité de la couche carbonée. Un dépôt assisté par plasma dans un réacteur de dépôt est en outre effectué généralement à plus haute pression que dans un réacteur de gravure. Le risque de gravure de la couche exposée dans les premières secondes du plasma est ainsi minimisé.

Selon un exemple le dépôt de la couche CₓH_{y}F_{z} 11 est un dépôt chimique à partir d'au moins un précurseur gazeux. L'au moins un précurseur gazeux peut comprendre les éléments carbone, hydrogène et fluor. L'au moins un précurseur gazeux peut être de formule chimique CᵤHᵥF_{w}, u, v et w étant des entiers positifs, au moins u et w étant non nuls. Selon un exemple u, v, et w sont non nuls. Le précurseur peut présenter une formule CᵤHᵥF_{w} ou CᵤF_{w} lorsque v=0, hors CF₄. Le précurseur est différent de CF₄ qui ne permet pas seul de déposer une couche fluorée 11 en surface de la couche exposée. Selon un exemple, lors du dépôt les gaz injectés comprennent du CF4 en association avec l'au moins un précurseur gazeux. Selon un exemple alternatif, lors du dépôt les gaz injectés ne comprennent pas de CF₄. Par exemple l'au moins un précurseur gazeux est choisi parmi les composés de formule CH₂F₂ et CHF₃, CH₃F, C₄F₈ et C₄F₆.

Selon un exemple, l'au moins un précurseur gazeux peut être de formule chimique CᵤF_{w}, u et w étant des entiers positifs non nuls, avec un précurseur à base d'hydrogène, par exemple H₂.

Le dépôt de la couche CₓH_{y}F_{z} 11 peut comprendre une injection du ou des précurseur(s) gazeux, éventuellement en mélange avec d'autres précurseurs et/ou un ou des gaz neutres. Selon un exemple, au moins un précurseur de formule chimique CᵤHᵥF_{w} peut être injecté seul, sans précurseur de formule chimique autre que CᵤHᵥF_{w}. Selon un exemple alternatif, un précurseur de formule chimique CᵤHᵥF_{w} peut être injecté avec l'ajout d'au moins un précurseur de de formule chimique autre que CᵤHᵥF_{w} ou CᵤF_{w} hors CF₄, par exemple un précurseurs CF₄, ou un précurseur à base d'oxygène et/ou d'azote, tel que O₂ ou N₂. Ces précurseurs permettent de limiter la polymérisation en surface des précurseurs CᵤHᵥF_{w} et de ralentir la vitesse de dépôt de la couche 11. Un meilleur contrôle du dépôt de la couche 11 est ainsi obtenu. De préférence, pour améliorer encore ce contrôle du dépôt, la quantité de précurseur de formule chimique CᵤHᵥF_{w} ou CᵤF_{w} hors CF₄ injectée, par exemple le débit, est sensiblement 4 et de préférence 5 fois supérieure ou égale à la quantité du ou des autre(s) précurseur(s), par exemple à leur débit.

Selon un exemple, le débit de précurseur(s) injecté(s) est sensiblement compris entre 5 et 50 sccm, de préférence entre 5 et 40 sccm (unité de centimètres cubes standards par minutes, abrégée de l'anglais *Standard Cubic Centimeters per Minute,* et couramment employée dans le domaine pour mesurer le débit d'un gaz). Selon un exemple, le débit de précurseur(s) injecté(s) de formule chimique CᵤHᵥF_{w} est sensiblement inférieur ou égal à 40 sccm et/ou sensiblement supérieur ou égal à 20 sccm. De préférence, le débit de précurseur(s) injecté(s) de formule chimique CᵤHᵥF_{w} ou CᵤF_{w} hors CF₄ est sensiblement égal à 35 sccm. La pression peut être sensiblement égale à 10 mT. Les débits et pression sont notamment choisis afin de contrôler la vitesse de dépôt et d'obtenir une bonne uniformité de la couche 11 déposée.

La température dans la chambre de réaction, de préférence la température du substrat, lors du dépôt de la couche 11, peut être comprise entre sensiblement 10°C et 250°C, de préférence inférieure ou égale à 100 °C, et de préférence sensiblement comprise entre 20 °C et 80 °C. La température dans la chambre de réaction peut être la température des parois de la chambre 20 et/ou la température du porte-échantillon 21. La puissance de la source plasma peut être comprise entre 200 W et 3000 W lors du dépôt de la couche 11.

Selon un exemple, lors du dépôt de la couche 11, un précurseur CH₂F₂ est injecté à un débit sensiblement égal à 35sccm, en complément de CF₄ à un débit de 5 sccm, à une pression de 10mTorr et une puissance RF du plasma Pₛ₋ₚₗₐₛₘₐ de 800W.

Le dépôt de la couche CₓH_{y}F_{z} 11 peut être configuré de sorte que la couche CₓH_{y}F_{z} 11 présente une épaisseur sensiblement supérieure ou égale à 1 nm, de préférence à 2 nm. Lors du développement de l'invention, il a été mis en évidence que cette épaisseur permettait une activation suffisante pour le collage ultérieur. Le dépôt de la couche CₓH_{y}F_{z} 11 peut être configuré de sorte que la couche CₓH_{y}F_{z} 11 présente une épaisseur sensiblement inférieure ou égale à 10 nm, de préférence à 5 nm. Le temps nécessaire au dépôt de la couche est ainsi limité, tout en permettant d'obtenir une activation suffisante pour le collage ultérieur. Le dépôt de la couche CₓH_{y}F_{z} 11 peut être configuré de sorte que la couche CₓH_{y}F_{z} 11 présente une épaisseur sensiblement comprise entre1 nm et 10 nm, et de préférence entre 2 nm et 5 nm.

Le traitement par le plasma d'activation 3 est maintenant décrit plus en détail. Le traitement par le plasma d'activation 3 peut comprendre une injection d'au moins un gaz dans la chambre de réaction et une formation du plasma d'activation 3 à partir du gaz. Le plasma d'activation 3 est à base de l'un au moins parmi de l'oxygène et de l'azote pour réagir avec la couche CₓH_{y}F_{z} 11. Par exemple, l'au moins un gaz injecté comprend du dioxygène et/ou du diazote. Le gaz peut être injecté en mélange avec un ou plusieurs gaz neutres, par exemple de l'hélium ou de l'argon. Selon un exemple, le débit de gaz injecté(s) est sensiblement compris entre 5 et 200 sccm. La pression dans la chambre de réaction peut être sensiblement comprise entre 30mTorr et 200 mTorr (avec 1 Torr égal environ à 133,322 pascals (Pa) dans le système international des unités). La température dans la chambre de réaction, de préférence la température du substrat, lors du plasma d'activation, peut être comprise entre sensiblement 10°C et 250°C. La puissance de la source plasma peut être comprise entre 200 W et 3000 W lors du plasma d'activation.

Le traitement par plasma d'activation 3 peut être continu. Selon un exemple alternatif, le traitement par plasma d'activation peut être pulsé. Durant la formation du plasma continu ou pulsé, les gaz sont de préférence injectés en continu.

Lors du traitement par le plasma d'activation 3 pulsé, le plasma pulsé peut être obtenu en faisant fonctionner par intermittence, de préférence périodiquement, la source du plasma et/ou la polarisation V_{bias-substrat} appliquée à la structure. L'application du plasma sur la structure est ainsi fractionnée dans le temps.

Selon un exemple, la tension d'auto-polarisation V_{bias-substrat} appliquée à la structure est pulsée, c'est-à-dire que l'application de la tension de polarisation comprend une succession alternativement d'application et de moindre application de la tension de polarisation à la structure. Selon un exemple, l'application de la tension de polarisation comprend une succession alternativement d'application et de non-application de la tension de polarisation à la structure. Selon un exemple, en alternance, une tension de polarisation V_{bias-substrat}1 et une tension de polarisation V_{bias-substrat}2 sont appliquées à la structure successivement, avec |V_{bias-substrat}2| < |V_{bias-substrat}1|, et de préférence |V_{bias-substrat}1| ≥ 5 |V_{bias-substrat}2| et plus préférablement |V_{bias-substrat}1| ≥ 10*|V_{bias-substrat}2|. De préférence, successivement en alternance, une tension d'auto-polarisation V_{bias-substrat}1 est appliquée à la structure et aucune tension d'auto-polarisation n'est appliquée à la structure.. Lorsqu'aucune tension d'auto- polarisation V_{bias-substrat}2 n'est volontairement appliquée à la structure 1, notons qu'une tension de polarisation résiduelle peut être appliquée à la structure, notamment en raison de phénomène de gaine dans le plasma. |V_{bias-substrat}2| peut alors être sensiblement égal à 20V, et plus particulièrement sensiblement égal à 15V. Le fait que le traitement plasma 3 est pulsé permet une plus grande fenêtre de paramètres pour minimiser la gravure de la couche exposée tout en permettant son activation.

Comme dit précédemment, le traitement par plasma d'activation 3 comprend une injection d'au moins un gaz dans la chambre de réaction 20 et une formation d'un plasma à partir de ce gaz. Le traitement peut en outre comprendre plusieurs cycles, chaque cycle comprenant une alternance d'une purge et de la formation d'un plasma, et ce cycle étant répété plusieurs fois lors du traitement. Ici aussi, l'application du plasma sur le substrat est fractionnée dans le temps. Ce traitement est donc désigné par le terme de plasma cyclique, par opposition à un traitement où le nettoyage est effectué par l'application d'un plasma de façon continue.

Le traitement par plasma d'activation peut comprendre au moins un et de préférence plusieurs cycles. Chaque cycle comprend au moins deux, et de préférence trois, étapes principales. Chaque cycle peut comprendre une étape habituellement qualifiée de purge. La purge a pour fonction d'évacuer les espèces gazeuses éventuellement présentes dans la chambre de réaction 20, par exemple d'évacuer les sous-produits réactionnels suite au traitement par plasma. Selon un exemple, dans le cycle, la purge est réalisée avant la formation du plasma. Ainsi, la composition du plasma formé est mieux contrôlée, pour s'assurer de la qualité du plasma obtenu. Cette purge consiste généralement à injecter dans la chambre de réaction 20 un gaz neutre tel que de l'argon ou de l'hélium.

Lors de la formation du plasma 3, une tension d'auto-polarisation, de préférence non-nulle, est appliquée. La tension d'auto-polarisation peut être appliquée à la chambre de réaction 20. Ainsi, l'énergie des ions du plasma d'activation peut être modulée pour améliorer l'efficacité du bombardement ionique sur la couche CₓH_{y}F_{z} 11 et donc l'activation de la couche exposée, tout en limitant la gravure de la couche exposée 10. Pour cela, la tension d'auto-polarisation peut être strictement inférieure à 0. La valeur absolue de la tension d'auto-polarisation peut être sensiblement supérieure ou égale à 100 V, de préférence à 200 V. La valeur absolue de la tension d'auto-polarisation peut être sensiblement inférieure ou égale à 500 V.

Le traitement par le plasma d'activation 3 peut être réalisé dans une chambre de réaction 20 d'un réacteur à gravure réactive (communément abrégé RIE, pour *Reactive Ion Etching*), comprenant les réacteurs CCP et ICP détaillés ci-dessous.

Le traitement par le plasma d'activation 3 peut selon un premier exemple être réalisé dans une chambre de réaction 20 d'un réacteur 2 plasma à couplage capacitif, habituellement qualifié par son acronyme CCP du terme anglais *Capacitively Coupled Plasma.* Dans un réacteur plasma à couplage capacitif, la tension d'auto-polarisation n'est pas dissociable de la puissance RF Pₛ₋ₚₗₐₛₘₐ fournie pour créer le plasma. Dans le cas d'un réacteur plasma de type CCP, la tension d'auto-polarisation est forcément non nulle. Les plasmas ainsi produits sont aptes à déposer une couche CₓH_{y}F_{z} 11 lors de l'étape de dépôt, et effectuer le plasma d'activation 3.

Le traitement par le plasma d'activation 3 peut selon un deuxième exemple être réalisé dans une chambre de réaction 20 d'un réacteur 2 plasma à couplage inductif, habituellement qualifié par son acronyme ICP du terme anglais *Inductively Coupled Plasma.* Dans un réacteur plasma à couplage inductif, la tension d'auto-polarisation est générée par la puissance RF appliquée au niveau du porte-échantillon 21. Elle correspond donc à une tension de polarisation appliquée à la structure ou de façon équivalente au substrat V_{bias-substrat}. La puissance RF appliquée au niveau de la source 25 du plasma réacteur détermine quant à elle la densité ionique du plasma. L'avantage d'un réacteur plasma de type ICP est donc de pouvoir dissocier le bombardement ionique sur le substrat de la densité du plasma. Un plasma à couplage inductif sera préféré, qui permet de contrôler indépendamment le V_{bias-substrat} par rapport à la puissance RF Pₛ₋ₚₗₐₛₘₐ de la source 25 du plasma pour un meilleur contrôle de la tension d'auto-polarisation, par dissociation de la tension appliquée au substrat et de la puissance RF du plasma Pₛ₋ₚₗₐₛₘₐ.

Ainsi, le bombardement ionique sur la couche CₓH_{y}F_{z} 11 et la gravure de la couche exposée 10 peuvent être encore mieux contrôlés et de préférence minimisés. Par conséquent, le collage subséquent sera amélioré. En outre, la qualité de l'interface entre la couche exposée 10 et la couche exposée 40 après assemblage de la structure 1 et du substrat 4 est améliorée.

En pratique, comme par exemple illustré par la figure 6, la chambre de réaction 20 comprend un plateau de réception 21 du substrat ou aussi porte-échantillon. Selon un exemple, la tension de polarisation V_{bias-substrat} est appliquée au plateau 21. De préférence, la tension de polarisation V_{bias-substrat} est appliquée uniquement au plateau 21. Selon cet exemple, le plateau 21 est conducteur électriquement et la tension de polarisation V_{bias-substrat} est appliquée à ce plateau 21 par un dispositif de régulation de la tension 26 pour être transmise à la structure 1. Le dispositif de régulation de la tension 26 est par exemple configuré pour appliquer une puissance RF au niveau du porte échantillon.

Selon un exemple, la valeur absolue de la tension de polarisation |V_{bias-substrat}| appliquée est sensiblement inférieure ou égale à 500 V. La valeur absolue de la tension de polarisation |V_{bias-substrat}| appliquée peut être sensiblement supérieure ou égale à 50 V. On notera que cette tension de polarisation est bien plus faible que les tensions de polarisation habituellement utilisées pour réaliser des implantations par plasma dans un réacteur CCP. En outre, ce procédé est de préférence mis en oeuvre dans un réacteur plasma de dépôt. Les réacteurs plasma de gravure ne sont pas configurés pour appliquer au substrat des tensions de polarisation aussi faibles.

La tension de polarisation V_{bias-substrat} peut être appliquée pendant au moins 70% de la durée de formation du plasma, de préférence au moins 90%, et encore plus préférentiellement pendant toute la durée de formation du plasma. Selon un exemple, la tension de polarisation V_{bias-substrat} est appliquée uniquement durant le traitement par le plasma d'activation 3. Selon un exemple, la tension de polarisation V_{bias-substrat} est appliquée uniquement lors de la formation du plasma, durant le traitement par le plasma d'activation 3.

Un réacteur ICP est maintenant décrit à titre d'exemple en référence à la figure 6. De manière relativement classique, le réacteur 2 comprend une entrée 22 des gaz permettant d'injecter à l'intérieur de la chambre 20 les gaz destinés à former la chimie du plasma ainsi que les gaz destinés aux phases de purge. La source plasma 25 est selon un exemple un dispositif de couplage par induction 25, dont une bobine est illustrée en figure 6, et qui permet la formation du plasma. La source plasma 25 peut être radiofréquence (abrégé RF-ICP sur la figure 6). Le réacteur 2 comprend également une valve 23 d'isolation de la chambre de réaction 20. Le réacteur 20 comprend également une pompe 24 configurée pour contrôler la pression à l'intérieur de la chambre de réaction 20 de façon synergique avec le débit des gaz injectés, et extraire les espèces présentes dans la chambre de réaction 20.

De manière avantageuse, ce réacteur 2 comprend un dispositif de polarisation 26 configuré pour permettre l'application de la tension de polarisation V_{bias-substrat} au plateau 21, par exemple via un générateur de puissance radiofréquence. Cette tension peut in fine être appliquée à la structure 1, tout au moins à sa face tournée au regard du plateau 21, que cette face soit électriquement conductrice ou non. Ce dispositif de polarisation 26 est de préférence distinct de la source plasma 25. Ce dispositif de polarisation 26 peut comprendre un dispositif de contrôle 260 configuré pour appliquer une tension alternative sur le plateau 21.

Selon cet exemple, le dispositif de polarisation 26 et la source plasma 25 sont configurés de sorte à pouvoir régler la tension de polarisation V_{bias-substrat} appliquée au plateau 21 indépendamment de la puissance RF Pₛ₋ₚₗₐₛₘₐ de la source 25 du plasma. V_{bias-substrat} et Pₛ₋ₚₗₐₛₘₐ peuvent être indépendantes. V_{bias-substrat} et Pₛ₋ₚₗₐₛₘₐ peuvent être contrôlées de manière indépendante.

Selon un exemple alternatif, lors de la formation du plasma d'activation 3, aucune tension Vbias-substrat n'est appliquée au substrat.

Exemples particuliers de réalisation et énergie de collage associée.

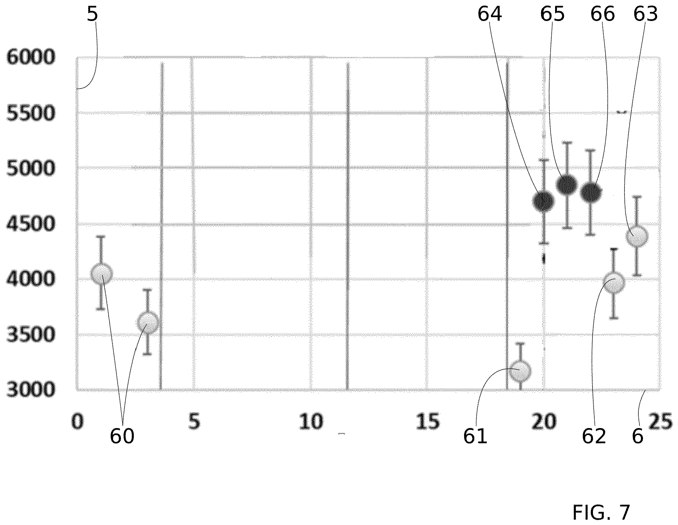

La figure 7 illustre l'énergie de collage 5 (en mJ.m⁻²) mesurée sur des assemblages. L'énergie de collage est mesurée en mesurant la quantité d'énergie nécessaire pour séparer les deux substrats formant l'assemblage. Ces assemblages sont des assemblages 6 de deux substrats par collage direct, l'un des substrats étant :
- 60 un substrat présentant une couche exposée activée par un plasma d'activation Oz dans un réacteur CCP, sans dépôt préalable d'une couche carbonée,
- 61 un substrat présentant une couche exposée activée par un plasma d'activation Oz dans un réacteur ICP, sans dépôt préalable d'une couche carbonée,
- 62 un substrat présentant une couche exposée activée par un dépôt d'une couche fluorée à partir de gaz CH₂F₂ et CF₄ ou O₂ ou N₂ sur les parois du réacteur puis un plasma d'activation Oz dans un réacteur CCP,
- 63 un substrat présentant une couche exposée activée par un dépôt d'une couche fluorée à partir de précurseur CH₂F₂ et CF₄ sur les parois du réacteur puis un plasma d'activation N₂ dans un réacteur de gravure réactive (communément abrégé RIE pour Réactive-Ion-Etching),
- 64 un substrat présentant une couche exposée activée par un dépôt d'une couche CₓH_{y}F_{z} sur la couche exposée puis un plasma d'activation Oz dans un réacteur RIE, selon un exemple de réalisation du procédé,
- 65 un substrat présentant une couche exposée activée par un dépôt d'une couche CₓH_{y}F_{z} sur la couche exposée puis un plasma d'activation N₂ dans un réacteur RIE, selon un exemple de réalisation du procédé,
- 66 un substrat présentant une couche exposée activée par un dépôt d'une couche CₓH_{y}F_{z} sur les parois du réacteur puis un plasma d'activation O₂ dans un réacteur RIE, selon un exemple de réalisation du procédé.

Dans ces exemples, les paramètres expérimentaux sont tels que décrit précédemment.

Les assemblages obtenus avec le procédé d'activation selon les exemples de réalisations ci-dessous permettent d'obtenir une énergie de collage supérieure à celles obtenues par les solutions existantes. Le dépôt d'une couche CₓH_{y}F_{z} préalablement à un traitement par un plasma d'activation permet d'augmenter l'activation de la couche exposée et donc l'énergie de collage de l'assemblage résultant. Pour les exemples 64 à 66, une ouverture de l'assemblage hors interface a même été observée lors des mesures d'énergie de collage, c'est-à-dire que les substrats sont séparés par cassure d'un des substrats en dehors de l'interface formée par leurs couches exposées. L'énergie de collage obtenue dans ces exemples est donc supérieure à l'énergie du matériau constitutif du substrat.

Au vu de la description qui précède, il apparaît clairement que l'invention propose un procédé améliorant le collage direct sur un substrat, et notamment permettant de limiter la gravure de la couche exposée.

L'invention s'étend également aux modes de réalisation dans lesquels la structure est déposée sur un substrat à base de silicium.

Par ailleurs, dans les exemples décrits ci-dessus la structure est une couche. Néanmoins, tous les exemples, caractéristiques, étapes et avantages techniques mentionnés ci-dessus en référence à une structure formant une couche sont applicables à une structure ne formant pas une couche mais formant une structure ponctuelle, par exemple un relief en trois dimensions. La structure peut être une nanostructure ou comprendre une pluralité de nanostructures.

## Revendications

1. Procédé d'activation d'une couche exposée (10) d'une structure (1) comprenant :
• une fourniture d'une structure (1) comprenant une couche exposée (10) dans un réacteur (2), le réacteur (2) comprenant une chambre de réaction (20) à l'intérieur de laquelle la structure (1) est disposée,
• avant ou après la fourniture de la structure (1), un dépôt dans la chambre de réaction (20) d'une couche (11) à base d'un matériau de formule chimique CₓH_{y}F_{z}, x, y et z étant des entiers positifs, au moins x et z étant non-nuls,
le procédé d'activation étant **caractérisé par le fait qu'**il comprend:
• un traitement, en présence de la structure (1), de la couche (11) à base d'un matériau de formule chimique CₓH_{y}F_{z} par un plasma d'activation (3) à base de l'un au moins parmi de l'oxygène et de l'azote, le traitement par le plasma d'activation (3) étant configuré pour consommer au moins en partie la couche (11) à base du matériau de formule chimique CₓH_{y}F_{z} de façon à activer la couche exposée (10) de la structure (1).

2. Procédé selon la revendication précédente, dans lequel la fourniture de la structure (1) est effectuée avant le dépôt dans la chambre de réaction (20), la couche (11) à base d'un matériau de formule chimique CₓH_{y}F_{z} étant alors déposée sur la couche exposée (10) de la structure (1).

3. Procédé selon la revendication précédente, dans lequel le dépôt de la couche (11) à base d'un matériau de formule chimique CₓH_{y}F_{z} et le traitement par le plasma d'activation (3) sont réalisés dans la même chambre de réaction (20).

4. Procédé selon la revendication 1, dans lequel la fourniture de la structure (1) est effectuée après le dépôt de la couche (11) à base d'un matériau de formule chimique CₓH_{y}F_{z} dans la chambre de réaction (20) et avant le traitement par le plasma d'activation (3), la couche (11) à base d'un matériau de formule chimique CₓH_{y}F_{z} étant alors déposée sur des parois (200) de la chambre de réaction (20), et le dépôt de la couche (11) à base d'un matériau de formule chimique CₓH_{y}F_{z} et le traitement par le plasma d'activation (3) étant réalisés dans la même chambre de réaction (20).

5. Procédé selon l'une quelconque des revendications précédentes, dans lequel le traitement par le plasma d'activation (3) est effectué de sorte à consommer au moins 90% et de préférence tous les atomes de carbone de la couche (11) déposée à base d'un matériau de formule chimique CₓH_{y}F_{z}.

6. Procédé selon l'une quelconque des revendications précédentes, dans lequel le traitement par le plasma d'activation (3) comprend l'application dans la chambre de réaction (20) d'une tension, dite tension d'auto-polarisation, de préférence la valeur absolue de la tension d'auto-polarisation est comprise entre 100 V et 500 V.

7. Procédé selon l'une quelconque des revendications précédentes, dans lequel le traitement par le plasma d'activation (3) est réalisé dans une chambre de réaction (20) d'un réacteur (2) plasma à couplage capacitif.

8. Procédé selon l'une quelconque des revendications 1 à 6, dans lequel le traitement par le plasma d'activation (3) est réalisé dans une chambre de réaction (20) d'un réacteur (2) plasma à couplage inductif, de préférence lors du traitement par le plasma d'activation (3), une tension de polarisation V_{bias-substrat} est appliquée à la structure (1).

9. Procédé selon l'une quelconque des revendications précédentes, dans lequel le dépôt de la couche (11) à base d'un matériau de formule chimique CₓH_{y}F_{z} est un dépôt chimique à partir d'au moins un précurseur gazeux, de préférence le dépôt est assisté par plasma.

10. Procédé selon la revendication précédente, dans lequel l'au moins un précurseur gazeux comprend au moins les éléments carbone, et fluor, l'au moins un précurseur gazeux étant différent de CF₄, l'au moins un précurseur gazeux étant de préférence de formule chimique CᵤHᵥF_{w}, u, v et w étant des entiers positifs, au moins u et w étant non-nuls et hors CF₄, par exemple l'au moins un précurseur gazeux est choisi parmi les composés de formule CH₂F₂ et CHF₃, CH₃F, C₄F₆ et C₄F₈.

11. Procédé selon l'une quelconque des revendications précédentes, dans lequel le traitement par le plasma d'activation (3) comprend une injection d'au moins un gaz dans une chambre de réaction (20) d'un réacteur (2) plasma et une formation du plasma d'activation (3) à partir dudit gaz dans la chambre de réaction (20), l'au moins un gaz comprenant du dioxygène, du diazote, de l'hélium ou leur mélange.

12. Procédé selon l'une quelconque des revendications précédentes, dans lequel la couche exposée (10) est à base de silicium, par exemple la couche exposée (10) est à base ou faite d'un oxyde de silicium, d'un nitrure de silicium ou de silicium.

13. Procédé selon l'une quelconque des revendications précédentes, comprenant, après le traitement par le plasma d'activation (3), l'assemblage par collage direct de la couche exposée (10) de la structure (1) avec une couche exposée (40) d'un substrat (4) distinct.

14. Procédé selon l'une quelconque des revendications précédentes, dans lequel au moins l'un parmi le dépôt de la couche (11) à base d'un matériau de formule chimique CₓH_{y}F_{z} et le traitement par le plasma d'activation (3) peuvent être répétés plusieurs fois.

15. Procédé de collage d'une couche exposée (10) d'une structure (1) avec une couche exposée (40) d'un substrat (4) distinct, le procédé comprenant :
• l'activation de la couche exposée (10) de la structure (1) en mettant en oeuvre le procédé selon l'une quelconque des revendications précédentes,
• la mise en contact de la couche exposée (10) de la structure avec la couche exposée du substrat (4) distinct.

## Patentansprüche

1. Verfahren zur Aktivierung einer belichteten Schicht (10) einer Struktur (1), das Folgendes umfasst:
• ein Einbringen einer Struktur (1), die eine belichtete Schicht (10) umfasst, in einen Reaktor (2), wobei der Reaktor (2) eine Reaktionskammer (20) umfasst, in deren Innerem die Struktur (1) angeordnet wird,
• vor oder nach dem Einbringen der Struktur (1) ein Abscheiden in der Reaktionskammer (20) einer Schicht (11), die auf einem Material mit der chemischen Formel CₓH_{y}F_{z} basiert, wobei x, y und z positive Ganzzahlen sind, wobei mindestens x und z nicht gleich null sind,
Aktivierungsverfahren **dadurch gekennzeichnet, dass** es Folgendes umfasst:
• eine Behandlung in Gegenwart der Struktur (1) der Schicht (11), die auf einem Material mit der chemischen Formel CₓH_{y}F_{z} basiert, durch ein Aktivierungsplasma (3) basierend auf mindestens einem von Sauerstoff und Stickstoff, wobei die Behandlung durch das Aktivierungsplasma (3) dazu konfiguriert ist, die Schicht (11) basierend auf dem Material mit der chemischen Formel CₓH_{y}F_{z} derart zu verbrauchen, dass die belichtete Schicht (10) der Struktur (1) aktiviert wird.

2. Verfahren nach dem vorstehenden Anspruch, wobei das Einbringen der Struktur (1) vor dem Abscheiden in der Reaktionskammer (20) erfolgt, wobei die Schicht (11), die auf einem Material mit der chemischen Formel CₓH_{y}F_{z} basiert, auf der belichteten Schicht (10) der Struktur (1) abgeschieden wird.

3. Verfahren nach dem vorstehenden Anspruch, wobei das Abscheiden der Schicht (11), die auf einem Material mit der chemischen Formel CₓH_{y}F_{z} basiert, und das Behandeln durch das Aktivierungsplasma (3) in derselben Reaktionskammer (20) realisiert werden.

4. Verfahren nach Anspruch 1, wobei das Einbringen der Struktur (1) nach dem Abscheiden der Schicht (11), die auf einem Material mit der chemischen Formel CₓH_{y}F_{z} basiert, in der Reaktionskammer (20) und vor dem Behandeln durch das Aktivierungsplasma (3) durchgeführt wird, wobei die Schicht (11), die auf einem Material mit der chemischen Formel CₓH_{y}F_{z} basiert, auf Wänden (200) der Reaktionskammer (20) abgeschieden wird, und das Abscheiden der Schicht (11), die auf einem Material mit der chemischen Formel CₓH_{y}F_{z} basiert, und das Behandeln durch das Aktivierungsplasma (3) in derselben Reaktionskammer (20) realisiert werden.

5. Verfahren nach einem der vorstehenden Ansprüche, wobei das Behandeln durch das Aktivierungsplasma (3) derart erfolgt, dass mindestens 90 % und bevorzugt sämtliche Kohlenstoffatome der aufgebrachten Schicht (11), die auf einem Material mit der chemischen Formel CₓH_{y}F_{z} basiert, verbraucht werden.

6. Verfahren nach einem der vorstehenden Ansprüche, wobei das Behandeln durch das Aktivierungsplasma (3) das Anlegen in der Reaktionskammer (20) einer Spannung, automatische Gittervorspannung genannt, umfasst, wobei der Absolutwert der automatischen Gittervorspannung bevorzugt zwischen 100 V und 500 V liegt.

7. Verfahren nach einem der vorstehenden Ansprüche, wobei das Behandeln durch das Aktivierungsplasma (3) in einer Reaktionskammer (20) eines kapazitiv gekoppelten Plasmareaktors (2) realisiert wird.

8. Verfahren nach einem der Ansprüche 1 bis 6, wobei das Behandeln durch das Aktivierungsplasma (3) in einer Reaktionskammer (20) eines induktiv gekoppelten Plasmareaktors (2), bevorzugt bei dem Behandeln durch das Aktivierungsplasma (3) realisiert wird, wobei eine Polarisationsspannung V_{bias-substrat} an die Struktur (1) angelegt wird.

9. Verfahren nach einem der vorstehenden Ansprüche, wobei das Abscheiden der Schicht (11), die auf einem Material mit der chemischen Formel CₓH_{y}F_{z} basiert, ein chemisches Behandeln ausgehend von mindestens einem gasförmigen Vorläufer ist, wobei das Abscheiden bevorzugt durch Plasma unterstützt wird.

10. Verfahren nach dem vorstehenden Anspruch, wobei der mindestens eine gasförmige Vorläufer mindestens die Elemente Kohlenstoff und Fluor umfasst, wobei sich der mindestens eine gasförmige Vorläufer von CF₄ unterscheidet, der mindestens eine gasförmige Vorläufer bevorzugt die chemische Formel C_{U}H_{V}F_{W} aufweist, wobei u, v und w positive Ganzzahlen sind, wobei mindestens u und w nicht null und nicht CF₄ sind, beispielsweise mindestens ein gasförmiger Vorläufer aus den Zusammensetzungen mit der Formel CH₂F₂ und CHF₃, CH₃F, C₄F₆ und C₄F₈ ausgewählt wird.

11. Verfahren nach einem der vorstehenden Ansprüche, wobei das Behandeln durch das Aktivierungsplasma (3) ein Einspritzen mindestens eines Gases in eine Reaktionskammer (20) eines Plasmareaktors (2) und ein Bilden des Aktivierungsplasmas (3) ausgehend von dem Gas in der Reaktionskammer (20) umfasst, wobei das mindestens eine Gas Disauerstoff, Distickstoff, Helium oder deren Mischungen umfasst.

12. Verfahren nach einem der vorstehenden Ansprüche, wobei die belichtete Schicht (10) auf Silizium basiert, die belichtete Schicht (10) beispielsweise auf einem Siliziumoxid, einem Siliziumnitrid oder Silizium basiert oder daraus hergestellt ist.

13. Verfahren nach einem der vorstehenden Ansprüche, das nach dem Behandeln durch das Aktivierungsplasma (3) das Zusammenfügen durch direktes Kleben der belichteten Schicht (10) der Struktur (1) mit einer belichteten Schicht (40) eines getrennten Substrats (4) umfasst.

14. Verfahren nach einem der vorstehenden Ansprüche, wobei mindestens eines des Abscheidens der Schicht (11), die auf einem Material mit der chemischen Formel CₓH_{y}F_{z} basiert, und des Behandelns durch das Aktivierungsplasma (3) mehrmals wiederholt werden kann.

15. Verfahren zum Kleben einer belichteten Schicht (10) einer Struktur (1) mit einer belichteten Schicht (40) eines getrennten Substrats (4), wobei das Verfahren Folgendes umfasst:
• das Aktivieren der belichteten Schicht (10) der Struktur (1), indem das Verfahren nach einem der vorstehenden Ansprüche umgesetzt wird,
• das Inkontaktbringen der belichteten Schicht (10) der Struktur mit der belichteten Schicht des getrennten Substrats (4).

## Claims

1. Method of activating an exposed layer (10) of a structure (1) comprising:
- a provision of a structure (1) comprising an exposed layer (10) in a reactor (2), the reactor (2) comprising a reaction chamber (20) inside which the structure (1) is disposed,
- before or after the provision of the structure (1), a deposition in the reaction chamber (20) of a layer (11) with the basis of a material of chemical formula CₓH_{y}F_{z}, x, y and z being positive integers, at least x and z being non-zero, the activation method being **characterised by** the fact that it comprises:
- a treatment, in the presence of the structure (1), of the layer (11) with the basis of a material of chemical formula CₓH_{y}F_{z} by an activation plasma (3) with the basis of at least one from among oxygen and nitrogen, the treatment by the activation plasma (3) being configured to consume at least partially the layer (11) with the basis of the material of chemical formula CₓH_{y}F_{z} so as to activate the exposed layer (10) of the structure (1).

2. Method according to the preceding claim, wherein the provision of the structure (1) is made before the deposition in the reaction chamber (20), the layer (11) with the basis of a material of chemical formula CₓH_{y}F_{z} thus being deposited on the exposed layer (10) of the structure (1).

3. Method according to the preceding claim, wherein the deposition of the layer (11) with the basis of a material of chemical formula CₓH_{y}F_{z} and the treatment by the activation plasma (3) are performed in the same reaction chamber (20).

4. Method according to claim 1, wherein the provision of the structure (1) is made after the deposition of the layer (11) with the basis of a material of chemical formula CₓH_{y}F_{z} in the reaction chamber (20) and before the treatment by the activation plasma (3), the layer (11) with the basis of a material of chemical formula CₓH_{y}F_{z} thus being deposited on walls (200) of the reaction chamber (20), and the deposition of the layer (11) with the basis of a material of chemical formula CₓH_{y}F_{z} and the treatment by the activation plasma (3) being performed in the same reaction chamber (20).

5. Method according to any one of the preceding claims, wherein the treatment by the activation plasma (3) is performed so as to consume at least 90% and preferably all the carbon atoms of the deposited layer (11) with the basis of a material of chemical formula CₓH_{y}F_{z}.

6. Method according to any one of the preceding claims, wherein the treatment by the activation plasma (3) comprises the application in the reaction chamber (20) of a voltage, called self-biasing voltage, preferably the absolute value of the self-biasing voltage is between 100V and 500V.

7. Method according to any one of the preceding claims, wherein the treatment by the activation plasma (3) is performed in a reaction chamber (20) of a capacitive coupling plasma reactor (2).

8. Method according to any one of claims 1 to 6, wherein the treatment by the activation plasma (3) is performed in a reaction chamber (20) of an inductive coupling plasma reactor (2), preferably during the treatment by the activation plasma (3), a biasing voltage V_{bias-substrate} is applied to the structure (1).

9. Method according to any one of the preceding claims, wherein the deposition of the layer (11) with the basis of a material of chemical formula CₓH_{y}F_{z} is a chemical deposition from at least one gaseous precursor, preferably the deposition is plasma-enhanced.

10. Method according to the preceding claim, wherein the at least one gaseous precursor comprises at least the carbon elements, and fluorine, the at least one gaseous precursor being different from CF₄, the at least one gaseous precursor being preferably of chemical formula CᵤHᵥF_{w}, u, v and w being positive integers, at least u and w being non-zero and outside of CF₄, for example, the at least one gaseous precursor is chosen from among the compounds of formula CH₂F₂ and CHF₃, CH₃F, C₄F₆ and C₄F₈.

11. Method according to any one of the preceding claims, wherein the treatment by the activation plasma (3) comprises an injection of at least one gas into a reaction chamber (20) of a plasma reactor (2) and a formation of the activation plasma (3) from said gas into the reaction chamber (20), the at least one gas comprising dioxygen, dinitrogen, helium or a mixture of them.

12. Method according to any one of the preceding claims, wherein the exposed layer (10) is silicon-based, for example, the exposed layer (10) is with the basis of or made of a silicon oxide, a silicon nitride or silicon.

13. Method according to any one of the preceding claims, comprising, after the treatment by the activation plasma (3), the assembly by direct bonding of the exposed layer (10) of the structure (1) with an exposed layer (40) of a distinct substrate (4).

14. Method according to any one of the preceding claims, wherein at least one from among the deposition of the layer (11) with the basis of a material of chemical formula CₓH_{y}F_{z} and the treatment by the activation plasma (3) can be repeated several times.

15. Method for bonding an exposed layer (10) of a structure (1) with an exposed layer (40) of a distinct substrate (4), the method comprising:
- the activation of the exposed layer (10) of the structure (1) by implementing the method according to any one of the preceding claims,
- the contacting of the exposed layer (10) of the structure with the exposed layer of the distinct substrate (4).
